# FASCICULE DE BREVET EUROPEEN

(11) **EP 3 238 269 B1**
(45) Date de publication et mention de la délivrance du brevet: **12.08.2020**
(21) Numéro de dépôt: 15820282.0
(22) Date de dépôt: 15.12.2015
(51) Int. Cl.: H01L 29/778, H01L 29/861, H01L 29/06, H01L 29/20

(54) **DISPOSITIF DE MODULATION COMPORTANT UNE NANO-DIODE**
MODULATIONSVORRICHTUNG MIT EINER NANODIODE
MODULATION DEVICE COMPRISING A NANODIODE

(30) Priorité: 22.12.2014 FR 1463140
(43) Date de publication de la demande: 01.11.2017
(73) Titulaire: Centre National de la Recherche Scientifique (C.N.R.S.), 75016 Paris (FR); Université de Lille 1 Sciences et Technologies, 59655 Villeneuve d'Ascq Cedex (FR)
(72) Inventeur: GAQUIERE, Christophe Pierre Paul, 59650 Villeneuve d'Ascq (FR); DUCOURNAU, Guillaume, 59310 Orchies (FR); FAUCHER, Marc, 59810 Lesquin (FR)
(74) Mandataire: Gevers & Orès
(86) Numéro de dépôt international: PCT/IB2015/059623
(87) Numéro de publication internationale: WO 2016/103111

(56) Documents cités:
- WO-A1-2014/134490
- WO-A2-02/086973
- WO-A2-2007/072405
- SONG A M ET AL: "Unidirectional electron flow in a nanometer-scale semiconductor channel: A self-switching device", APPLIED PHYSICS LETTERS, AMERICAN INSTITUTE OF PHYSICS, 2 HUNTINGTON QUADRANGLE, MELVILLE, NY 11747, vol. 83, no. 9, 1 septembre 2003 (2003-09-01), pages 1881-1883, XP012035982, ISSN: 0003-6951, DOI: 10.1063/1.1606881
- SANGARE PAUL ET AL: "Zero-bias GaN implanted Self-Switching Diode coupled with bow-tie antenna for THz applications", 2014 44TH EUROPEAN MICROWAVE CONFERENCE, EUROPEAN MICROWAVE ASSOCIATION, 6 octobre 2014 (2014-10-06), pages 806-809, XP032706806, DOI: 10.1109/EUMC.2014.6986557
- MATEOS J ET AL: "Noise and Terahertz rectification in semiconductor diodes and transistors", NOISE AND FLUCTUATIONS (ICNF), 2011 21ST INTERNATIONAL CONFERENCE ON, IEEE, 12 juin 2011 (2011-06-12), pages 16-21, XP032038873, DOI: 10.1109/ICNF.2011.5994291 ISBN: 978-1-4577-0189-4
- SÁNCHEZ-MARTÍN H ET AL: "Voltage controlled sub-THz detection with gated planar asymmetric nanochannels", APPLIED PHYSICS LETTERS, A I P PUBLISHING LLC, US, vol. 113, no. 4, 043504, 25 July 2018 (2018-07-25), pages 1-4, XP012230270, ISSN: 0003-6951, DOI: 10.1063/1.5041507 [retrieved on 2018-07-25]

## Description

La présente invention concerne un dispositif de modulation comportant au moins une nano-diode.

Le domaine de l'invention est notamment celui de la détection en très haute fréquence, dans la gamme de l'ordre du terahertz.

Les nano-diodes à auto-commutation dites SSD (pour "Self-Switching nanoDiodes" en anglais) sont l'une des solutions les plus prometteuses pour atteindre cette gamme de fréquence et répondre ainsi aux multiples applications en cours de développement. En effet, ces composants requièrent une seule étape de nano-lithographie afin de réaliser des tranchées dans le semi-conducteur. Or de telles étapes sont coûteuses et impactent fortement le rendement de fabrication.

Les composants sont donc planaires : il est ainsi très aisé de les associer afin de réaliser des matrices ou des réseaux de détection. Le substrat utilisé permet par ailleurs un couplage avec des optiques adaptées aux fréquences terahertz.

Au sujet des nano-diodes, on citera l'article suivant qui est incorporé ici par référence :
« Experimental demonstration of direct terahertz detection at room temperature in AIGaN/GaN asymmetric nanochannels » SANGARE P., DUCOURNAU G., GRIMBERT B., BRANDLI V., FAUCHER M., GACQUIERE C., INIGUEZ-DE-LA-TORRE A., INIGUEZ-DE-LA-TORRE I., MILLITHALER J.F., MATEOS J., GONZALES T. - Journal of Applied Physics 1/3, 3 (2013) page 034305 et suivantes.

La qualité d'un détecteur peut s'évaluer à sa sensibilité de détection. De plus, afin d'améliorer le rapport signal sur bruit produit par des détecteurs en général et à nano-diodes en particulier, une solution connue consiste à utiliser un hachoir mécanique ("chopper" en anglais), qui découpe (module) le signal qui doit être détecté. La difficulté liée à cette solution repose sur l'utilisation d'un composant mécanique externe au composant, qui est encombrant, impossible à intégrer et qui limite la fréquence de découpage à quelques milliers de hertz (< 10000 Hz en général).

La présente invention a ainsi pour objet d'augmenter le rapport signal sur bruit d'un dispositif de détection à nano-diodes sans recourir à un hachoir mécanique.

Selon l'invention, un dispositif de modulation est réalisé sur un substrat comportant au moins une nano-diode qui se présente comme un T encastré dans un U, le canal de cette nano-diode étant la jambe du T qui pénètre dans le U ; ce dispositif est remarquable en ce qu'il comporte au moins une ligne électriquement conductrice qui passe par-dessus une partie au moins de ce canal.

Avantageusement, le dispositif comportant une pluralité de nano-diodes juxtaposées, la ligne enjambe la totalité des canaux.

Eventuellement, une couche d'un matériau diélectrique est interposée entre le ou les canaux et la ligne.

Suivant un mode de réalisation préférentiel, le substrat est en silicium.

De préférence, la ou les nano-diodes sont formées dans une hétérostructure AIGaN/GaN.

A titre d'exemple, la ligne est réalisée avec un mélange d'or et de molybdène ou bien elle est réalisée à partir d'une multicouche telle que titane/platine/or.

L'invention vise encore un procédé de commande du dispositif qui comprend une étape d'alimentation de la ligne.

La présente invention apparaîtra maintenant avec plus de détails dans le cadre de la description qui suit d'exemples de réalisation donnés à titre illustratif en se référant aux figures annexées qui représentent :
- la figure 1, une nano-diode élémentaire selon l'invention, plus particulièrement :
   + la figure 1a, un schéma en perspective,
   + la figure 1b, une vue de dessus ;
- la figure 2, un ensemble de nano-diodes selon l'invention.

Les éléments présents dans plusieurs figures sont affectés d'une seule et même référence.

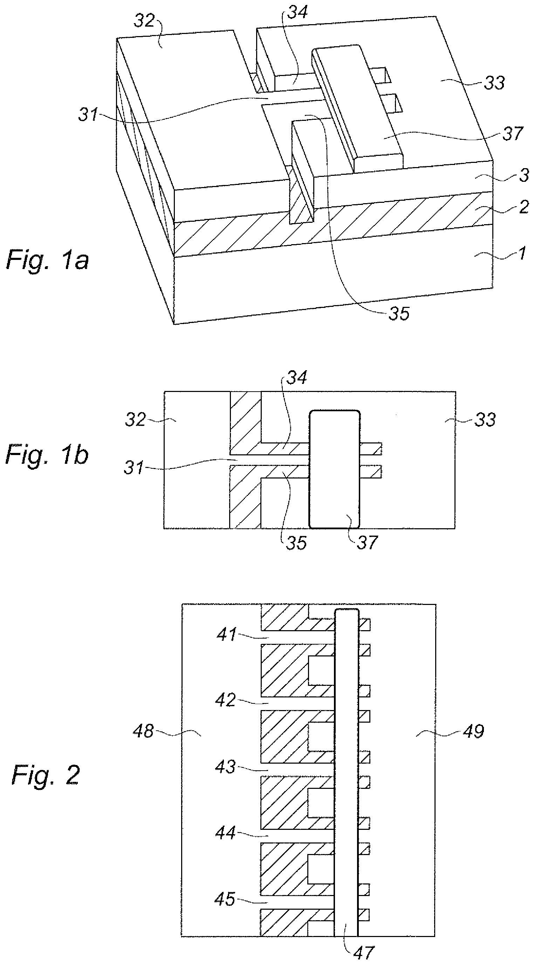

En référence à la figure 1, une nano-diode est gravée dans une hétérostructure bicouche déposée sur un substrat 1 qui est en silicium dans le cas présent.

L'hétérostructure comporte une couche inférieure 2 au contact du substrat et une couche supérieure 3.

A titre d'exemple, la couche inférieure 2 est en GaN et la couche supérieure 3 est en Al₀,₃Ga₀,₇N.

La nano-diode est gravée dans la couche supérieure 3.

Elle se présente comme un T, à gauche sur la figure, encastré dans un U, à droite sur la figure. La jambe 31 du T qui s'appuie sensiblement au milieu de la barre 32 de ce T débouche dans la base 33 du U. Elle constitue le canal de la diode qui s'étend par conséquent de la barre 32 jusqu'à la base 33. De part et d'autre du canal 31 figurent deux tranchées 34, 35 qui se prolongent pour former un espace libre entre la barre 32 du T et le sommet du U.

Une ligne conductrice 37 est agencée sur le canal 31, perpendiculairement à celui-ci et elle repose sur les deux montants du U. A titre d'exemple, pour réaliser cette ligne, on commence par déposer une couche mince de métal sur la diode et ensuite on vient graver cette couche

La ligne peut être un mélange d'or et de molybdène. Elle peut aussi consister en une tri-couche titane-platine-or. En tout état de cause, quelle que soit sa constitution, le point important est que cette ligne soit électriquement conductrice.

On réalise ainsi un contact Schottky entre la ligne 37 et le canal 31.

On peut par ailleurs envisager de déposer une couche d'un matériau diélectrique entre la nano-diode et la ligne.

Une seule nano-diode ne peut transmettre qu'un courant très limité du fait de la section de son canal, Il est ainsi connu de juxtaposer une pluralité de nano-diodes.

En référence à la figure 2, on a représenté un ensemble de cinq nano-diodes qui présentent donc cinq canaux 41, 42, 43, 44, 45 débouchant dans une zone d'accès gauche 48 et une zone d'accès droite 49.

Maintenant, la ligne conductrice 47 enjambe la totalité des canaux.

La connectique n'est pas représentée sur les figures afin de ne pas les surcharger. De plus, elle est bien connue de l'homme du métier qui n'a aucune difficulté pour la réaliser.

La fonction de la ligne est celle d'un interrupteur dont l'état dépend de la tension appliquée à cette ligne.

L'interrupteur est ouvert lorsqu'on applique une tension négative de l'ordre de 5 volts. Il est fermé lorsqu'on applique une tension nulle ou légèrement positive.

On remplace ainsi avantageusement le "chopper" pour améliorer le rapport signal sur bruit en commandant la ligne en mode tout ou rien.

De plus, il est possible d'ajuster la tension sur la ligne en mode passant afin d'avoir une sensibilité beaucoup plus élevée que pour une nano-diode sans ligne. On peut obtenir un facteur compris entre 10 et 100 pour une tension positive de l'ordre de 0,6 volts.

En fait la fonction de la ligne peut s'assimiler à celle de la grille d'un transistor.

La conséquence en est que la ligne peut être utilisée non seulement en tout ou rien mais également en tant que modulateur du courant qui s'écoule dans le canal.

La présente invention a été présentée suivant des modes de réalisations particulièrement pertinents. Toutefois, de nombreuses variantes pourraient être imaginées par l'homme du métier sans sortir du cadre de cette invention. En particulier, tout moyen décrit peut être remplacé par un moyen équivalent.

## Revendications

1. Dispositif de modulation réalisé sur un substrat (1) comportant au moins une nano-diode qui se présente comme un T encastré dans un U, le T comportant une barre (32) et une jambe (31) s'appuyant sensiblement au milieu de la barre, la jambe du T débouchant dans la base du U, le canal (31, 41, 42, 43, 44, 45) de cette nano-diode étant la jambe du T qui pénètre dans le U,
**caractérisé en ce qu'**il comporte au moins une ligne électriquement conductrice (37, 47) qui passe par-dessus une partie au moins de ce canal, ladite ligne électriquement conductrice reposant sur deux montants du U, ladite ligne électriquement conductrice ayant la fonction d'interrupteur du dispositif et/ou de modulateur du courant qui s'écoule dans le canal.

2. Dispositif selon la revendication 1 **caractérisé en ce que**, comportant une pluralité de nano-diodes juxtaposées, ladite ligne (47) enjambe la totalité des canaux (41, 42, 43, 44, 45).

3. Dispositif selon l'une quelconque des revendications 1 ou 2, **caractérisé en ce qu'**une couche d'un matériau diélectrique est interposée entre le ou les canaux (31, 41, 42, 43, 44, 45) et ladite ligne (37, 47).

4. Dispositif selon l'une quelconque des revendications précédentes, **caractérisé en ce que** ledit substrat (1) est en silicium.

5. Dispositif selon l'une quelconque des revendications précédentes, **caractérisé en ce que** la ou les nano-diodes sont formées dans une hétérostructure AlGaN/GaN (2, 3).

6. Dispositif selon l'une quelconque des revendications précédentes, **caractérisé en ce que** ladite ligne (37, 47) est réalisée avec un mélange d'or et de molybdène.

7. Dispositif selon l'une quelconque des revendications 1 à 5, **caractérisé en ce que** ladite ligne (37, 47) est réalisée à partir d'une multicouche conductrice.

8. Dispositif selon la revendication 7, **caractérisé en ce que** ladite multicouche conductrice est réalisée en titane/platine/or.

9. Procédé de commande du dispositif conforme à l'une quelconque des revendications précédentes, **caractérisé en ce qu'**il comprend une étape d'alimentation de ladite ligne (37, 47).

## Patentansprüche

1. Modulationsvorrichtung, die auf einem Substrat (1) realisiert ist, mit mindestens einer Nanodiode in Form eines T, das in ein U eingelassen ist, wobei das T einen Balken (32) und ein Bein (31) umfasst, das im Wesentlichen in der Mitte des Balkens anliegt, wobei das Bein des T in die Basis des U mündet, wobei der Kanal (31, 41, 42, 43, 44, 45) dieser Nanodiode das Bein des T ist, das in das U eindringt,
**dadurch gekennzeichnet, dass** sie mindestens eine elektrisch leitende Leitung (37, 47) umfasst, die über mindestens einen Teil dieses Kanals verläuft, wobei die elektrisch leitende Leitung auf zwei Schenkeln des U aufliegt und die elektrisch leitende Leitung die Funktion zum Schalten der Vorrichtung und/oder zum Modulieren des in dem Kanal fließenden Stroms erfüllt.

2. Vorrichtung nach Anspruch 1, **dadurch gekennzeichnet, dass** die Leitung (47), die eine Vielzahl von nebeneinander angeordneten Nanodioden umfasst, alle Kanäle (41, 42, 43, 44, 45) überspannt.

3. Vorrichtung nach einem der Ansprüche 1 oder 2, **dadurch gekennzeichnet, dass** eine Schicht aus einem dielektrischen Material zwischen dem Kanal oder den Kanälen (31, 41, 42, 43, 44, 45) und der Leitung (37, 47) angeordnet ist.

4. Vorrichtung nach einem der vorstehenden Ansprüche, **dadurch gekennzeichnet, dass** das Substrat (1) aus Silizium besteht.

5. Vorrichtung nach einem der vorstehenden Ansprüche, **dadurch gekennzeichnet, dass** die Nanodiode(n) in einer AlGaN/GaN-Heterostruktur (2, 3) ausgeformt ist/sind.

6. Vorrichtung nach einem der vorstehenden Ansprüche, **dadurch gekennzeichnet, dass** die Leitung (37, 47) mit einer Mischung aus Gold und Molybdän gebildet wird.

7. Vorrichtung nach einem der Ansprüche 1 bis 5, **dadurch gekennzeichnet, dass** die Leitung (37, 47) aus einer leitenden Mehrfachschicht gebildet wird.

8. Vorrichtung nach Anspruch 7, **dadurch gekennzeichnet, dass** die leitende Mehrfachschicht aus Titan/Platin/Gold besteht.

9. Verfahren zum Steuern der Vorrichtung in Übereinstimmung mit einem der vorstehenden Ansprüche, **dadurch gekennzeichnet, dass** es einen Schritt der Versorgung der Leitung (37, 47) umfasst.

## Claims

1. A modulation device made on a substrate (1) including at least one nanodiode which appears as T fitted into a U, the T comprising a bar (32) and a leg (31) being substantially supported at the middle of the bar (32), the leg (31) opening into the base of the U, the channel (31, 41, 42, 43, 44, 45) of this nanodiode being the leg of the T which penetrates into the U,
**characterized in that** it includes at least one electrically conductive line (37, 47) which passes over at least one portion of this channel, said conductive line resting on both uprights of the U, said conductive line having the function of a switch of the device and/or of a modulator of the current which flows in the channel.

2. The device according to claim 1, **characterized in that**, including a plurality of juxtaposed nanodiodes, said line (47) steps over the totality of the channels (41, 42, 43, 44, 45).

3. The device according to any of claims 1 or 2, **characterized in that** a layer of dielectric material is interposed between the channel(s) (31, 41, 42, 43, 44, 45) and said line (37, 47).

4. The device according to any of the preceding claims, **characterized in that** said substrate (1) is in silicon.

5. The device according to any of the preceding claims, **characterized in that** the nanodiode(s) is(are) formed in a AIGaN/GaN heterostructure (2, 3).

6. The device according to any of the preceding claims, **characterized in that** said line (37, 47) is made with a mixture of gold and of molybdenum.

7. The device according to any of claims 1 to 5, **characterized in that** said line (37, 47) is made from a conductive multilayer.

8. The device according to claim 7, **characterized in that** said conductive multilayer is made in titanium/platinum/gold.

9. A method for controlling the device according to any of the preceding claims, **characterized in that** it comprises a step for powering said line (37, 47).
